(19) Europäisches Patentamt
European Patent Office
Office européen des brevets

(11) **EP 4 089 421 B1**

(12) **FASCICULE DE BREVET EUROPEEN**

(45) Date de publication et mention
de la délivrance du brevet:
**27.12.2023 Bulletin 2023/52**

(21) Numéro de dépôt: **21173660.8**

(22) Date de dépôt: **12.05.2021**

(51) Classification Internationale des Brevets (IPC):
***G01R 23/17*** *(2006.01)*

(52) Classification Coopérative des Brevets (CPC):
**G01R 23/17; G06N 3/04; G06N 3/0675;** G06N 3/08

(54) **DISPOSITIF D'ANALYSE DE SPECTRE DE SIGNAUX RADIOFREQUENCES**

GERÄT ZUR SPEKTRALANALYSE VON FUNKFREQUENZSIGNALEN

DEVICE FOR SPECTRUM ANALYSIS OF RADIOFREQUENCY SIGNALS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**16.11.2022 Bulletin 2022/46**

(73) Titulaires:
- **Université Paris Cité**
  **75006 Paris (FR)**
- **Centre national de la recherche scientifique**
  **75016 Paris (FR)**

(72) Inventeurs:
- **Zakari, DENIS**
  **75012 Paris (FR)**
- **FAVERO, Ivan**
  **75012 Paris (FR)**
- **CIUTI, Cristiano**
  **75005 Paris (FR)**

(74) Mandataire: **Demulsant, Xavier**
**Dejade & Biset**
**8 Avenue Jean Bart**
**95000 Cergy (FR)**

(56) Documents cités:
| | |
|---|---|
| **FR-A- 2 775 790** | **FR-A1- 3 057 399** |
| **US-A- 4 695 790** | **US-A- 5 481 183** |
| **US-A1- 2018 131 445** | **US-A1- 2019 212 377** |
| **US-B1- 6 307 655** | |

**Description**

DOMAINE TECHNIQUE

L'invention se rapporte au domaine technique de l'analyse de spectre de signaux radiofréquences.

ART ANTERIEUR

L'invention concerne l'extraction de caractéristiques contenues dans le spectre de signaux radiofréquences.

Par radiofréquences on désigne ici les fréquences d'onde électromagnétique comprises entre 3 Hz et 300 GHz, incluant les fréquences utilisées pour la téléphonie mobile, le wifi, ainsi que les signaux employés notamment pour les radars.

L'invention trouve ainsi des applications dans le traitement de signaux dans des domaines tels que les télécommunications, les radars Doppler pulsés ou la spectroscopie ; domaines dans lesquels le taux d'analyse spectrale de signaux analogiques est critique.

Le développement des communications conduit à une utilisation du spectre électromagnétique de plus en plus intense (densité de signaux par unité de fréquence), et pour des fréquences maximales de plus en plus grandes. De plus, beaucoup d'émetteurs utilisent des techniques de saut de fréquence.

L'analyse des émissions nécessite donc d'augmenter la bande passante instantanée, ainsi que la dynamique et la résolution spectrale et temporelle des moyens d'analyse spectrale. Pour beaucoup d'applications, l'analyse spectrale devrait être la plus sensible que possible, permettant de détecter des signaux faibles par rapport au bruit ambiant.

Les méthodes numériques connues d'analyse spectrale consistent à numériser les signaux reçus par une antenne, avant de procéder à un traitement numérique, par exemple par transformée de Fourier rapide.

Ces méthodes numériques présentent de nombreux inconvénients.

Ces techniques nécessitent des convertisseurs analogiques-numériques très rapides, le taux d'échantillonnage limitant la plus haute fréquence analysable.

Les convertisseurs, lorsqu'ils ne présentent pas une bonne linéarité, génèrent des fréquences fantômes par production d'harmoniques.

Un signal échantillonné avec une haute fréquence et une large bande génère une quantité de données trop importante pour un traitement ultérieur par un calculateur placé en aval. Pour pallier ce problème, certaines méthodes numériques d'analyse spectrale fonctionnent par balayage. Mais si le balayage est effectué par exemple sur 20 GHz, sur chaque sous bande de 1GHz, avec une bande passante instantanée (real-time bandwidth) de 1 GHz, l'analyseur est aveugle 95% du temps.

De telles techniques ne permettent pas la détection d'émissions furtives de très courtes durées, par exemple des pulses uniques ultracourts. Le taux d'échantillonnage, de l'ordre de la centaine de mégahertz, limite le taux de traitement (throughput) à plusieurs centaines de kilohertz ainsi que la bande passante instantanée (real-time bandwidth).

Pour éviter les inconvénients de l'analyse par balayage, il pourrait être imaginé d'utiliser plusieurs analyseurs fonctionnant en parallèle, afin de couvrir une grande bande spectrale. Les dispositifs obtenus sont toutefois très coûteux, lourds, et encombrants.

On connait par ailleurs des analyseurs de spectres acousto-optiques, dans lesquels le signal à analyser est injecté dans un cristal piézoélectrique (cellule de Bragg) après avoir été converti en ondes acoustiques qui créent des variations d'indices de diffraction. La lumière laser est introduite dans le milieu transparent de la cellule acousto-optique, et cette lumière est diffractée en fonction du spectre du signal initial. L'image du laser est recueillie par un système CCD. L'amplitude du signal sortant est proportionnelle à l'amplitude du signal radiofréquence et l'angle de déflexion est quasi proportionnel à la fréquence du signal. Les analyseurs acousto-optiques ont été employés en radioastronomie. On peut se référer par exemple au document WO 20141 16128.

Dans le domaine des fréquences optiques, l'analyse spectrale est réalisable au moyen de spectromètres tels que les monochromateurs. Ce type de dispositifs effectue un balayage en fréquence assorti à une mesure de puissance à la fréquence sélectionnée, à une certaine résolution spectrale près. Le pilotage de l'élément mécanique du spectromètre permettant le balayage en fréquence limite grandement le taux d'acquisition du spectre des signaux à analyser, pouvant atteindre la dizaine de kilohertz pour les dispositifs les plus performants.

Dans le domaine des radars Doppler pulsés, la position et la vitesse de cibles en mouvement sont déterminées par l'analyse spectrale d'un signal pulsé réfléchi, réalisée numériquement suite à l'échantillonnage du pulse réfléchi, mesuré par une antenne. Le faible taux de répétition des pulses limite la vitesse maximale des cibles traçables.

Dans le domaine des télécommunications, diverses applications telles que la modulation par déplacement de fréquence (frequency-shift keying, FSK) requièrent l'évaluation, aussi rapide que possible, et le suivi d'une fréquence dominante d'un signal analogique encodant des données. Cela peut actuellement être réalisé par des compteurs de fréquence (frequency counters) électroniques, dont la grande efficacité n'est malheureusement pas résiliente à la présence de bruit. Le document US5481183A présente un dispositif d'analyse de spectre de signaux radiofréquences.

L'invention vise à pallier au moins en partie les inconvénients des dispositifs et procédés connus dans l'état de la technique.

Un premier objet de l'invention est de permettre l'extraction de caractéristiques contenues dans le spectre de signaux radiofréquences bruités, à une cadence supérieure à 10 MHz, avantageusement supérieure au gigahertz, par l'utilisation d'un dispositif optoélectronique.

Un deuxième objet de l'invention est de permettre une telle extraction qui soit plus résiliente au bruit que les techniques de l'art antérieur.

Un troisième objet de l'invention est de permettre une telle extraction opérant à des taux de traitement (throughput) supérieurs à ceux des techniques de l'art antérieur.

Un autre objet de l'invention est de permettre la détermination de la distribution spectrale d'énergie d'un pulse radiofréquence ainsi que la fréquence du maximum de ce spectre, dans un temps de l'ordre de quelques dizaines de picosecondes et ce malgré la présence éventuelle de bruit.

Un autre objet de l'invention est de permettre la réalisation d'une mesure ultra-rapide de la fréquence d'un signal sinusoïdal continu bruité.

Un autre objet de l'invention est un dispositif photonique intégré permettant d'atteindre au moins un des objets présentés ci-dessus.

A ces fins, l'invention se rapporte, selon un premier aspect, à un dispositif optoélectronique d'extraction de caractéristiques contenues dans le spectre de signaux radiofréquences analogiques continus ou pulsés, bruités, formant un signal analogique d'entrée, le dispositif optoélectronique d'extraction comprenant:

- un module d'entrée générant une onde optique porteuse et effectuant une modulation de cette porteuse optique par le signal d'entrée analogique, par multiplication/mélange, pour former un signal optique modulé;
- un réseau de cavités optiques linéaires couplées et pompées optiquement par tout ou partie du signal optique modulé, acheminé au réseau par un moyen d'amener de la lumière ;
- un dispositif de mesure optique directe ou indirecte de quantités mesurées des champs optiques qui sont : des intensités, des amplitudes et/ou des phases des champs optiques au sein des cavités linéaires couplées, ces champs optiques étant induits par le signal optique modulé par le signal analogique d'entrée ;
- un module de calcul relié au dispositif de mesure optique, effectuant une transformation linéaire sur les quantités mesurées des champs optiques, par multiplication avec une matrice W et addition d'un vecteur de biais b,

    pour permettre de reconstruire et d'extraire des caractéristiques ciblées contenues dans le spectre du signal d'entrée radiofréquence,
    le module de calcul ayant effectué un apprentissage machine sur des signaux radiofréquences analogiques bruités d'entrainement présentant les mêmes caractéristiques ciblées, afin de déterminer la matrice W et le vecteur de biais b.

L'invention se rapporte, selon un deuxième aspect, à un procédé d'extraction de caractéristiques contenues dans le spectre de signaux radiofréquences analogiques continus ou pulsés, bruités, formant un signal analogique d'entrée, le procédé d'extraction utilisant le dispositif tel que présenté ci-dessus, et comprenant :

- une étape de mélange/multiplication du signal d'entrée radiofréquence par modulation d'une onde porteuse optique, pour former un signal optique modulé ;
- une étape de couplage et pompage optique d'un réseau de cavités optiques linéaires par tout ou partie du signal optique modulé ;
- une étape de mesure des intensités, amplitudes et/ou phases des champs optiques des cavités ;
- une étape de transformation linéaire sur les quantités mesurées associées aux champs ;
- une étape d'apprentissage machine pour la transformation linéaire.

Selon divers modes de réalisation, le dispositif présente les caractères suivants, le cas échéant combinés :

- les cavités optiques linéaires sont couplées par des couplages fixes ou aléatoires ;

- les cavités optiques linéaires sont réalisées sous la forme de structures nanométriques ou micrométriques, gravées dans un matériau semi-conducteur ou diélectrique, arrangées dans un réseau de cavités optiques de géométrie planaire, le réseau de cavités optiques comprenant des couplages directs entre sites plus proches voisins, ou indirects entre sites arbitrairement éloignés ; ces cavités optiques peuvent avoir des formes arbitraires, c'est-à-dire « ne dépendant que de la volonté de l'ingénieur », pour traduire l'absence de véritables contraintes techniques externes sur la géométrie du réseau planaire (carré, triangulaire, hexagonal, etc.) et leur fabrication;

- le réseau de cavités optiques est implémenté sur une puce photonique.

La puce photonique comprend avantageusement des résonateurs en anneaux latéralement couplés.

La puce photonique comprend avantageusement un réseau de micro ou nano-piliers.

La puce photonique comprend avantageusement un réseau planaire de cavités optiques en forme de disque.

La puce photonique comprend avantageusement un réseau planaire de cavités fondées sur des cristaux photoniques.

Dans certaines mises en oeuvre, la puce photonique est en silicium et/ou dioxyde de silicium.

Dans certaines mises en oeuvre, le réseau de cavités optiques est un ensemble désordonné ou ordonné de diffuseurs optiques linéaires, formant un matériau dense ou un milieu dilué diffusant.

Selon diverses réalisations, le dispositif présente en outre les caractères suivants, le cas échéant combinés :

- le module d'entrée effectuant la modulation de la porteuse optique par le signal d'entrée analogique comprend un modulateur électro-optique ;

- le module d'entrée génère plusieurs ondes porteuses optiques différentes modulées par le signal d'entrée ;

- les signaux d'entrée radiofréquences analogiques ont une fréquence limitée par le module d'entrée ;

- le réseau de cavités optiques présente au moins $5 \times 5$ cavités optiques.

La matrice W est avantageusement entrainée pour permettre d'extraire les caractéristiques ciblées suivantes :

- la densité spectrale, c'est-à-dire le spectre, du signal d'entrée
- la fréquence d'un pic identifié dans ce spectre,
- la forme spectrale d'un pulse, par exemple gaussienne ou lorentzienne.

Selon diverses réalisations, le dispositif présente les caractères suivants, le cas échéant combinés :

- le dispositif comprend un démultiplexeur optique séparant les signaux émis par les différents modes normaux du réseau de cavités, de longueur d'onde différente ;

- le module effectuant la transformation linéaire comprend une unité électronique de calcul arithmétique, formant un circuit logique programmable, le circuit logique programmable étant avantageusement un réseau de portes programmables *in situ* ;

- le dispositif de mesure optique des quantités associées aux champs des cavités optiques comprend une caméra disposée en regard de la structure du réseau de cavités, et est apte à mesurer l'intensité, l'amplitude et/ou la phase de la lumière rayonnée par chaque cavité ;

- le dispositif de mesure optique des quantités associées aux champs des cavités optiques comprend des guides d'onde couplés en champ proche aux cavités optiques linéaires, et est apte à mesurer l'intensité, l'amplitude et/ou la phase de la lumière émise aux fréquences propres du réseau.

L'invention se rapporte, selon un autre aspect, à un dispositif optoélectronique d'extraction de caractéristiques contenues dans le spectre de signaux radiofréquences analogiques continus ou pulsés, bruités, formant un signal analogique d'entrée, le dispositif optoélectronique d'extraction comprenant:

- un module d'entrée générant une onde optique porteuse et effectuant une modulation de cette porteuse optique par le signal d'entrée analogique, par multiplication/mélange, pour former un signal optique modulé;
- un réseau de cavités optiques linéaires couplées et pompées optiquement par tout ou partie du signal optique modulé, acheminé au réseau par un moyen d'amener de la lumière ;
- un module d'optique linéaire en aval du réseau de cavités linéaires, permettant d'obtenir N' superpositions linéaires à partir de N champs optiques $\alpha_n$ rayonnées par les cavités du réseau, le m-ième signal ainsi généré s'exprimant sous la forme d'une somme pondérée de ces champs, par exemple de la forme

$$x_m = W_{m1}\alpha_1 + W_{m2}\alpha_2 + \ldots + W_{mN}\alpha_N + b_m$$

dont la matrice de poids W et le vecteur de biais b peuvent être fixés de manière externe et sont avantageusement issus d'un processus d'apprentissage machine sur des signaux radiofréquences analogues bruités d'entraînement ;

- un dispositif de mesure optique des intensités, des amplitudes et/ou des phases des N' superpositions linéaires $x_m$ des champs optiques rayonnés par les cavités linéaires couplées, la mesure produisant avantageusement des caractéristiques ciblées sous la forme d'un vecteur de nombres.

Selon diverses réalisations, le dispositif présente les caractères suivants, le cas échéant combinés :

- la matrice de poids W est une matrice de nombres complexes ;

- le module d'optique linéaire en aval du réseau de cavités comprend un dispositif d'optique adaptative agissant sur l'amplitude et/ou la phase des champs rayonnés ;

- le dispositif d'optique adaptative comprend un modulateur spatial de lumière ;

- le dispositif d'optique adaptative comprend une matrice de micro-miroirs agissant sur l'amplitude et/ou la phase des champs rayonnés ;

- le module d'optique linéaire en aval du réseau de cavités comprend un dispositif d'optique fibrée ou intégrée.

L'invention se rapporte, selon un autre aspect, à un procédé d'extraction de caractéristiques contenues dans le spectre de signaux radiofréquences analogiques continus ou pulsés, bruités, formant un signal analogique d'entrée, le procédé d'extraction utilisant un dispositif tel que présenté ci-dessus, et comprenant :

- une étape de mélange/multiplication du signal d'entrée radiofréquence par modulation d'une onde porteuse optique, pour former un signal optique modulé ;
- une étape de couplage et pompage optique d'un réseau de cavités optiques linéaires par tout ou partie du signal optique modulé ;
- une étape de superposition linéaire des champs optiques rayonnés par les cavités du réseau ;
- une étape de mesure optique des intensités, des amplitudes et/ou des phases des superpositions linéaires des champs optiques rayonnés par les cavités linéaires couplées, chaque superposition linéaire des champs optiques rayonnés par les cavités du réseau s'exprimant sous la forme d'une somme pondérée de ces champs, dont la matrice de poids W et le vecteur de biais sont issus d'un apprentissage machine sur des signaux radiofréquences analogiques bruités d'entraînement.

L'invention se rapporte, selon un autre aspect à l'utilisation d'un dispositif tel que présenté ci-dessus, à la détermination de la densité spectrale d'un signal radiofréquence, ou à la détermination de la fréquence angulaire d'un maximum ciblé dans le spectre d'un signal radiofréquence, ou à la détermination de la fréquence d'un signal harmonique.
L'invention se rapporte, selon un autre aspect, à l'utilisation d'un dispositif tel que présenté ci-dessus, dans les télécommunications, par exemple pour décoder des signaux issus de protocole FSK, ou à l'analyse radar Doppler pulsé.
L'invention se rapporte, selon un autre aspect, à l'application d'un procédé tel que présenté ci-dessus, pour la détermination de la densité spectrale d'énergie et/ou la fréquence dominante d'un pulse radiofréquence.

BREVE DESCRIPTION DES DESSINS

Les caractéristiques et avantages de l'invention apparaîtront à la lecture de la description qui va suivre, donnée uniquement à titre d'exemple, et faite en référence aux dessins annexés, dans lesquels :

- la figure 1 est un schéma de principe d'un procédé d'extraction de caractéristiques contenues dans le spectre de signaux radiofréquences, selon une mise en oeuvre de l'invention ;

- la figure 2 est un schéma de principe d'un dispositif d'extraction de caractéristiques contenues dans le spectre de signaux radiofréquences, selon une mise en oeuvre de l'invention ;

- la figure 3 est une représentation schématique du dispositif de la figure 2, dans une implémentation télécom fibrée ;

- la figure 4 est une représentation des performances du procédé selon l'invention, pour un réseau 30x30 cavités, pour plusieurs valeurs de rapport signal sur bruit SNR ;

- la figure 5 est une comparaison des performances du procédé selon l'invention avec les performances d'une transformée de Fourier rapide du signal avec un taux d'échantillonnage supposé idéal, pour plusieurs valeurs de rapport signal sur bruit SNR ;

- la figure 6 est une comparaison des probabilités de présence du pic de puissance maximale obtenues par entraînement d'un dispositif selon l'invention, pour plusieurs valeurs de rapport signal sur bruit SNR ;

- la figure 7 illustre les capacités d'un dispositif selon l'invention pour la mesure ultra-rapide de la fréquence d'un signal sinusoïdal continu bruité, pour un rapport signal sur bruit de SNR égal à 20.

## DESCRIPTION DETAILLEE DE MODES DE REALISATIONS

Il est proposé un dispositif optoélectronique et un procédé permettant l'extraction de caractéristiques (feature extraction) contenues dans le spectre de signaux radiofréquences bruités, à une cadence supérieure au gigahertz.

Le dispositif optoélectronique associe un dispositif photonique de prétraitement et d'un dispositif de calcul numérique élémentaire préalablement entraîné par apprentissage machine (machine learning).

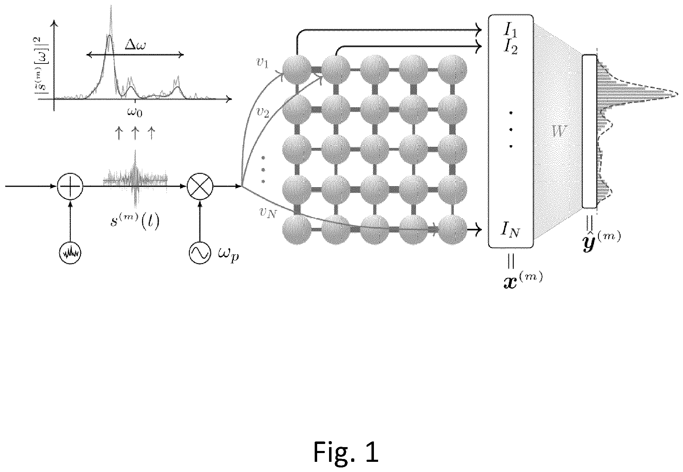

Le principe du procédé est schématisé en figure 1.

Le procédé comprend une étape de mélange/multiplication du signal d'entrée radiofréquence $s^{(m)}(t)$ par modulation d'une onde porteuse optique de fréquence angulaire $\omega_p$, pour former un signal optique modulé. La fréquence angulaire $\omega_p$ de la porteuse est avantageusement choisie telle que

$$\omega_p = \omega - \omega_0,$$

où $\omega$ désigne le centre du spectre d'un réseau de cavités optiques (typiquement la moyenne de la fréquence angulaire des cavités optiques) et $\omega_0$, le centre de la gamme spectrale sur laquelle l'analyse des signaux d'entrée veut être réalisée.

Le procédé comprend une étape de couplage et pompage optique d'un réseau de cavités optiques linéaires par tout ou partie du signal optique modulé.

Le procédé comprend une étape de mesure des intensités, amplitudes et/ou phases des champs optiques des N cavités (M valeurs numériques formant un vecteur de nombres de taille M noté $x^{(m)}$)

Le procédé comprend une étape de transformation linéaire sur les quantités mesurées associées aux champs, retournant de nouveaux vecteurs $(\hat{y}_1^{(m)}, ..., \hat{y}_K^{(m)})$ de la forme

$$\hat{y}_i^{(m)} = W_i \cdot x^{(m)} + b_i$$

par multiplication avec une matrice W et addition d'un vecteur de biais b.

Le procédé comprend une étape d'apprentissage machine pour la transformation linéaire, pour déterminer les paramètres W et b.

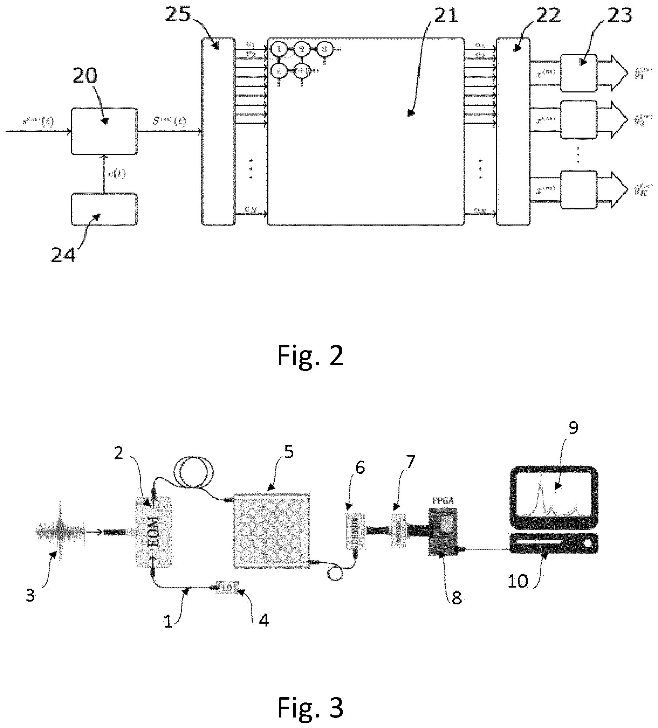

Le procédé est avantageusement mis en oeuvre par un dispositif représenté en figure 3, ou schématisé en figure 2.

Dans une mise en oeuvre de type télécom fibrée, représentée en figure 3, une porteuse 1 à une fréquence télécom est modulée par un modulateur électro-optique 2 (EOM) en fonction du signal radiofréquence 3 d'entrée.

Dans le mode de réalisation schématisé en figure 3, le signal radiofréquence 3 d'entrée est un signal bruité, de type pulse.

Dans d'autres modes de réalisation, non représentés, le signal radiofréquence d'entrée est un signal continu, bruité ou non.

Les divers éléments ne sont pas représentés à l'échelle en figure 3.

La porteuse 1 est par exemple issue d'une diode laser télécom 4.

Le signal sortant du modulateur 2 est acheminé vers une puce photonique 5.

Dans une mise en oeuvre, la puce photonique 5 est une puce planaire en silicium comprenant des micro-anneaux résonateurs latéralement couplés. Un résonateur en micro-anneau comprend un anneau, typiquement d'une taille allant de quelques microns à quelques dizaines de microns, et un ou deux guides d'ondes droits. Dans les résonateurs en micro-anneau à couplage latéral, les guides et l'anneau sont fabriqués avec la même couche. Les micro-anneaux peuvent se présenter sous forme de cercle, ou d'hippodrome (racetrack), ou encore de disque.

Le champ modulé est couplé aux anneaux du réseau par un premier guide d'onde. Le rayonnement émis par la structure à chaque fréquence propre du réseau est extrait au moyen d'un second guide d'onde.

Un démultiplexeur optique 6 sépare les signaux émis par les divers modes normaux, de longueurs d'onde différentes, dont on mesure l'intensité au moyen d'un capteur 7.

Dans une mise en oeuvre, le capteur 7 comprend une rangée de photodiodes.

Les intensités mesurées sont transformées par un composant 8, afin d'obtenir le spectre du pulse radiofréquence initial.

Dans certaines mises en oeuvre, le composant 8 est un composant électronique programmable, notamment de type FPGA (Field Programmable Gate Array) comprenant un réseau de cellules programmables.

Le spectre du pulse radiofréquence initial 3 est présenté sur un écran 9 d'un terminal 10, par exemple un ordinateur, un serveur, ou un terminal de communication mobile.

Il est proposé un dispositif optoélectronique, schématisé en figure 2, comprenant avantageusement quatre modules consécutivement traversés par le signal d'entrée à analyser :

- un module 20 opérant un mélange du signal radiofréquence d'entrée $s^{(m)}(t)$ avec une porteuse optique c(t), par modulation de cette dernière,
- un réseau 21 de cavités optiques linéaires mutuellement couplées et pompées optiquement par la porteuse optique modulée par le signal,
- un capteur 22 mesurant directement ou indirectement les populations optiques des cavités du réseau 21,
- un module 23 opérant sur les quantités mesurées une transformation linéaire préalablement optimisée afin de maximiser la quantité d'information efficacement extraite du signal d'entrée.

L'optimisation préalable des paramètres de la transformation linéaire, opérée par apprentissage machine sur un ensemble de signaux connus, permet au dispositif optoélectronique de réaliser une extraction de caractéristiques plus résiliente au bruit que l'état de l'art, tout en opérant à des taux de traitement (throughput) supérieurs.

Le dispositif optoélectronique se distingue également des dispositifs existants d'analyse spectrale radiofréquence, par le transfert d'une majorité des opérations d'analyse à un système physique non électronique, avantageusement un système optique.

Le signal radiofréquence d'entrée et ses caractéristiques (features) sont transposés sur une porteuse optique, et l'extraction de caractéristiques est permise par les interactions optiques entre cavités et par la mesure optique.

Le dispositif optoélectronique est capable, a minima, de déterminer la distribution spectrale d'énergie d'un pulse radiofréquence, la fréquence angulaire du maximum de ce spectre, ainsi que la fréquence d'un signal harmonique, dans un temps de l'ordre de quelques dizaines de picosecondes.

Cette performance, qui dépasse l'état de l'art, peut être atteinte en dépit de la présence de bruit indésirable.

Le dispositif optoélectronique est favorablement exploité dans le domaine des télécommunications, e.g. modulation par déplacement de fréquence (frequency-shift keying, FSK) ; de l'imagerie, e.g. techniques de pulse-Doppler radar ; ou encore de l'apprentissage machine, e.g. comme étape de prétraitement (encodage numérique non trivial de signaux analogiques) ou coprocesseur optique.

Le dispositif optoélectronique est muni d'au moins une entrée acceptant des signaux radiofréquences continus ou pulsés et d'une sortie numérique.

Le dispositif optoélectronique comprend plusieurs sous-parties, schématisées en figure 2.

Une première sous-partie du dispositif est un module comprenant un oscillateur local optique 24 générant une porteuse optique c(t), et un modulateur 20 de signal, e.g. mélangeur/multiplicateur.

Le modulateur 20 génère un signal $S^{(m)}(t)$, par modulation en phase ou en amplitude de la porteuse optique c(t) en fonction du signal d'entrée radio fréquence $s^{(m)}(t)$.

Dans certaines mises en oeuvre, plusieurs modulateurs 20 sont mis en oeuvre, afin de générer plusieurs signaux optiques modulés à partir d'un même signal d'entrée $s^{(m)}(t)$.

Pour les simulations numériques du dispositif présentées ci-dessous, la modulation par un multiplicateur (frequency mixer) d'une seule porteuse optique a été utilisée.

La porteuse optique, d'amplitude complexe c(t), est caractérisée par une fréquence et une amplitude complexe. La fréquence angulaire $\omega_p$ de la porteuse

$$c(t) \sim \exp(-i\omega_p t)$$

est choisie telle que

$$\omega_p = \omega - \omega_0,$$

où $\omega$ désigne le centre du spectre du réseau 21 de cavités optiques (typiquement la moyenne de la fréquence angulaire des cavités optiques) et $\omega_0$, le centre de la gamme spectrale sur laquelle l'analyse des signaux d'entrée veut être réalisée.

La largeur $\Delta\omega$ de cette gamme est égale à la largeur spectrale du réseau 21 ($\Delta\omega \approx 4J_{max}$, pour un réseau carré de cavités avec des constantes de couplage entre cavités J uniformément distribuées entre 0 et $J_{max}$), de sorte que, pour ce choix de $\omega_p$, le dispositif opère son analyse dans la gamme radiofréquence $[\omega_0-\Delta\omega/2 \; ; \; \omega_0+\Delta\omega/2]$.

Une deuxième sous-partie du dispositif est un système 25 permettant d'acheminer le signal optique ainsi généré aux divers sites du réseau 21 de cavités optiques. L'amplitude du pompage effectif des sites du réseau 21 (i.e. des cavités individuelles constituant le réseau) est proportionnelle à l'amplitude du signal optique acheminé jusqu'au site, avec toutefois des coefficients de proportionnalité $v_n$ pouvant dépendre du site.

Cet acheminement peut être réalisé de diverses façons dans une implémentation photonique: au moyen de guides d'onde optiques couplés latéralement aux cavités, par champ proche, ou par éclairage en champ lointain des sites du réseau.

Une troisième sous-partie du dispositif est un réseau 21 de N cavités optiques linéaires couplées et pompées par tout ou partie du signal optique modulé. À chaque site correspond une cavité optique avec au minimum un mode optique utile.

De telles cavités peuvent être réalisées de façon intégrable, notamment sous la forme de nano/micro-structures, qui peuvent être gravées dans un même bloc de matériau semiconducteur ou diélectrique. Le réseau de cavités peut être de géométrie en principe arbitraire dans le plan, avec des couplages directs entre sites plus proches voisins, ou indirects entre sites arbitraires.

Dans une mise en oeuvre, le réseau 21 est un réseau de micro-piliers semiconducteurs, qui rend la mesure de populations optiques très simple par apposition verticale d'un capteur en regard de la matrice de cavités.

Dans une autre mise en oeuvre, le réseau 23 est un réseau planaire de cavités optiques en anneaux.

L'amplitude maximale de la plage de fréquences auxquelles le dispositif sera sensible dépend essentiellement de la valeur absolue du couplage entre les cavités.

Ainsi, le choix de cavités à très haute fréquence (plus petites) est avantageusement privilégié, afin de maximiser cette amplitude spectrale. Cette quantité peut être optimisée par des simulations numériques et caractérisée a posteriori sur les réseaux réalisés.

Les caractéristiques physiques du réseau ne dépendent que de sa fabrication et des conditions de son environnement (température, etc.), et aucunement du signal d'entrée, et sont supposées stables dans le temps. Chaque mode optique est décrit par une fréquence propre et un taux de relaxation.

En l'absence de signal d'entrée, la population photonique de ces modes, ainsi que leur état, en général, est fixée, éventuellement par un pompage optique supplémentaire indépendant des signaux d'entrée.

Les signaux optiques modulés entrants agissent sur ces modes sous la forme d'un pompage cohérent et induisent une modification mesurable de leurs populations photoniques. Les couplages J entre cavités voisines sont de nature à induire des corrélations spatiales entres les populations ou les cohérences des excitations stockées dans des cavités distinctes. Les valeurs J de ces couplages présentent généralement une hétérogénéité spatiale au sein du réseau planaire.

Une quatrième sous-partie du dispositif est un dispositif 22 réalisant une mesure de l'amplitude, la phase ou l'intensité des champs optiques des cavités optiques, par exemple, la mesure de l'intensité $I_n$ de la lumière rayonnée par chaque cavité n, au moyen d'une caméra disposée en regard de la structure de réseau ; ou la mesure des populations photoniques des modes optiques normaux du réseau couplé, par exemple par la mesure de l'intensité de la lumière émise aux fréquences propres du réseau dans un guide d'onde optique couplé en champ proche.

Ce dispositif 22 retourne les quantités mesurées (M valeurs, n variant de 1 à N ; typiquement M=N) en format numérique sous la forme d'un vecteur de nombres de taille M noté $x^{(m)}$, où m est l'indice associé au m-ième signal d'entrée $s^{(m)}(t)$ à analyser. Ce vecteur contient les quantités mesurées pendant le temps d'intégration du capteur en régime transitoire ou à l'état stationnaire mais pourrait aussi agréger plusieurs mesures séparées dans le temps.

Une cinquième sous-partie du dispositif comprend une ou plusieurs unités électroniques de calcul arithmétique 23, e.g. des field-programmable gate array (FPGA), capables de réaliser des transformations affines du vecteur issu du dispositif précédent, retournant de nouveaux vecteurs ($\hat{y}_1^{(m)}$,...,$\hat{y}_K^{(m)}$) de la forme

$$\hat{y}_i^{(m)} = W_i \cdot x^{(m)} + b_i$$

et aux dimensions éventuellement différentes de celles du vecteur précédent.

Les paramètres ($W_i, b_i$) des transformations affines décrites ci-dessus doivent pouvoir être ajustés arbitrairement au moins une première fois, au cours du processus d'optimisation associé à la tâche d'analyse.

Mais une fois fixés en sortie d'optimisation, les paramètres $(W_i, b_i)$ demeurent indépendants du signal d'entrée. Les valeurs de ces paramètres sont choisies de sorte qu'ils minimisent certaines fonctions de coût définies par la tâche d'analyse.

Le processus d'entraînement (apprentissage) a avantageusement lieu en une unique étape préliminaire selon le schéma suivant :

(i) Un ensemble de $N_{train}$ signaux d'entraînement $s^{(m)}(t)$ (m= 1,...,$N_{train}$), dont K caractéristiques d'intérêt (*target*) descriptibles par une série de vecteurs $(y_1^{(m)},...,y_K^{(m)})$ sont connues (e.g. par l'utilisation de l'art antérieur ou par la maîtrise de leur génération), sont transmis en entrée du dispositif, générant $N_{train}$ vecteurs de quantités mesurées $(x^{(1)},...,x^{(Ntrain)})$.

(ii) Chaque vecteur est transformé par les unités de calcul arithmétique afin d'obtenir une série de prédictions $(\hat{y}_1^{(m)},...,\hat{y}_K^{(m)})$ associées au caractéristiques ciblées $(y_1^{(m)},...,y_K^{(m)})$.

(iii) Les prédictions associées au m-ième signal $(\hat{y}_1^{(m)},...,\hat{y}_K^{(m)})$ dépendent paramétriquement des poids $(W_i, b_i)$ (avec i = 1,...,K).

Ainsi, il est possible d'optimiser ces poids, de sorte que l'erreur $E_{train}$ entre les prédictions $(\hat{y}_1^{(m)},...,\hat{y}_n^{(m)})$ et les quantités ciblées $(y_1^{(m)},...,y_n^{(m)})$ soit minimisée.

Cette erreur peut toujours être minimisée itérativement par des algorithmes de l'état de l'art, tels que, e.g., la descente de gradient, sans nécessité de réévaluer les vecteurs $(x^{(1)},...,x^{(Ntrain)})$.

En particulier, pour un choix typique de fonction d'erreur exprimée comme les moindres carrés, $E_{train} = \Sigma_{m,i}|\hat{y}_i^{(m)} - y_i^{(m)}|^2$, éventuellement complémentée de régularisation *ridge*, les poids optimaux peuvent être déterminés par une simple inversion de matrice.

(iv) Une fois les poids des unités arithmétiques $(W_i, b_i)$ fixés à leur valeurs optimum, la qualité de la prédiction peut être évaluée sur une série de $N_{test}$ signaux de test $s^{(m)}(t)$ dont les caractéristiques ciblées sont également connues à l'avance mais auxquels le dispositif n'a jamais été exposé.

De la sorte, on obtient en l'erreur $E_{test}$ du dispositif, sur l'ensemble des signaux de test, une bonne estimation de l'efficacité du dispositif lorsqu'il est confronté à des signaux inconnus.

Les performances de l'invention vont maintenant être présentées.

Différentes simulations numériques, dans diverses configurations, permettent de comparer les performances de l'invention à celles d'une transformée de Fourier rapide numérique.

Le détail de ces simulations est donné ci-après.

La réponse au m-ième signal modulé $S^{(m)}(t)$ du réseau de cavités optiques linéaires peut être fidèlement modélisée au moyen du système d'équations différentielles suivant :

$$\frac{d\alpha_\ell(t)}{dt} = \left[i(\Delta_\ell + \omega_0) - \kappa_\ell/2\right]\alpha_\ell(t) + i\sum_{m\in v(\ell)} J_{\langle m,\ell\rangle}\alpha_m(t) + iv_\ell S^{(m)}(t),$$

où

$\alpha_\ell$ désigne le champ optique de $\ell$-ième cavité ;

$\Delta_\ell = \omega_p - \omega_\ell$, le detuning de la $\ell$-ième cavité ;

$\omega_\ell$, la fréquence angulaire de la $\ell$-ième cavité ;

$\omega_0$, le centre de la bande spectrale à analyser ;

$\kappa_\ell$, le taux de dissipation de la $\ell$-ième cavité ;

$J_{\langle m,\ell\rangle}$ le couplage cohérent entre les cavités m et $\ell$ ;

$v_\ell$, le poids du couplage du signal d'entrée au site $\ell$.

Le capteur est modélisé par une moyenne temporelle des intensités

$$I_\ell(t) = |\alpha_\ell(t)|^2$$

sur un temps supérieur au temps de relaxation $1/K_\ell$, résultant en un vecteur d'intensités $x^{(m)}$.

La transformation affine paramétrée est réalisée par une simple multiplication matricielle $\hat{y}^{(m)} = Wx'^{(m)}$, où $x'^{(m)} = (1, x^{(m)})^T$, dont les poids W sont optimisés numériquement lors de l'étape d'entraînement.

L'exemple de l'extraction de densité spectrale d'énergie (ESD) de pulses en présence de bruit par un réseau carré de $L \times L$ cavités linéaires est décrit en détail ci-après.

Un ensemble de pulses $s^{(m)}(t)$ est généré par transformée de Fourier inverse à partir de $N_{train}$ spectres complexes aléatoires $s^{(m)}[\omega]$, avec

$$s^{(m)}[\omega] = TF\{s^{(m)}(t)\},$$

dont la densité spectrale d'énergie,

$$ESD^{(m)}[\omega] = |s^{(m)}[\omega]|^2,$$

est dotée d'une certaine structure (i.e. plus corrélée que du bruit).

Puis, du bruit blanc est additionné, jusqu'à atteindre un certain rapport signal sur bruit, noté SNR.

Ce rapport SNR est ici choisi comme le rapport des énergies du signal et du bruit sur la plage de fréquences angulaires d'intérêt $[\omega_0-\Delta\omega/2 ; \omega_0+\Delta\omega/2]$.

Les spectres d'entraînement et de test, connus, sont uniformément échantillonnés en un ensemble de $N_b$ bins de la forme

$$y_k^{(m)} = ESD^{(m)}[\omega_0-\Delta\omega/2+(k-1)\Delta\omega/(N_b-1)].$$

Par ailleurs, l'intégration numérique du système d'équations décrit plus haut aboutit à $N_{train}$ vecteurs $x'^{(m)}$, de dimension $L^2+1$, que l'on transforme par une matrice W de taille $N_b \times (L^2+1)$ tel que $\hat{y}^{(m)} = Wx'^{(m)}$, ces derniers vecteurs constituent l'évaluation du spectre par le dispositif.

Pour cette tâche, l'entraînement consiste à trouver la matrice $W_*$ minimisant l'écart entre les spectres non bruités de départ $y^{(m)}$, que l'on cherche à déterminer, et les prédictions faites par le dispositif $\hat{y}^{(m)}$.

De façon équivalente, on cherche l'optimum de l'erreur quadratique moyenne régularisée

$$C[W] = (1/N_{train})\Sigma_m|\hat{y}^{(m)} - y^{(m)}|^2 + (\lambda/2)|W|_2^2$$

où le dernier terme est un terme de régularisation ridge.

Pour cette fonction de coût, la matrice optimum $W_*$ est donnée analytiquement par

$$W_*{}^T = (X^TX + \lambda 1)^{-1}X^TY$$

où

$$X_{ij} = x'_j^{(i)} \text{ et } Y_{ij} = y_j^{(i)}.$$

L'hyperparamètre $\lambda$ de la régularisation ridge est ajusté par grid search au cours d'une procédure de validation croisée à 10 blocs sur l'ensemble d'entraînement.

Une fois la matrice W fixée à sa valeur optimum $W_*$, précédemment déterminée, les prédictions du dispositif pour un m-ième signal sont données par $\hat{y}^{(m)} = W_*x'^{(m)}$.

Afin d'en évaluer la précision, l'on génère $N_{test}$ nouveaux pulses aléatoires bruités, auxquels le dispositif n'a jamais été exposé lors de l'entraînement, puis on évalue la quantité relative d'énergie du pulse mal classifiée

$$\Delta E/E_0 = (1/N_{test})\Sigma_m|\hat{y}^{(m)} - y^{(m)}|/|y^{(m)}|,$$

métrique pertinente pour quantifier l'erreur sur cette tâche.

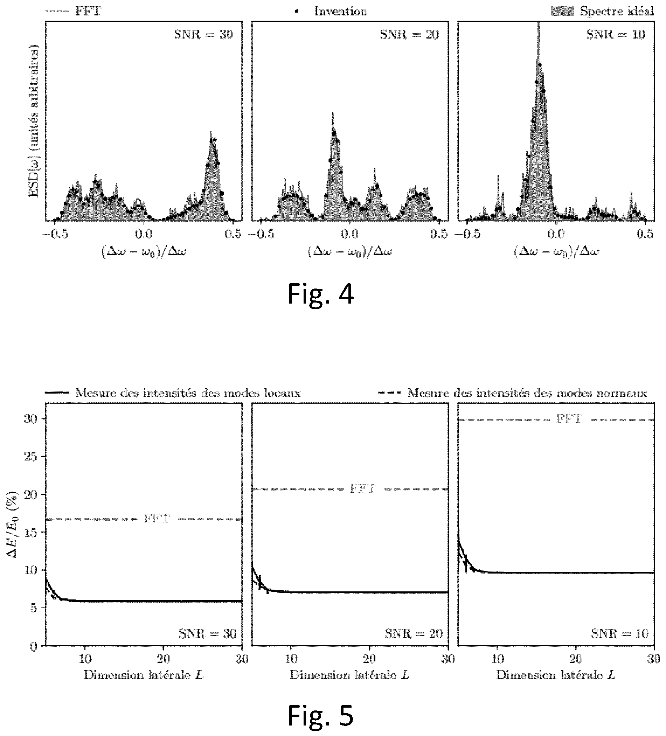

La performance typique de l'invention pour un réseau 21 de $30 \times 30$ cavités est illustrée en figure 4, sur 3 parmi les 3000 signaux de l'ensemble de test pour plusieurs valeurs du rapport signal sur bruit SNR.

Le spectre original avant l'addition de bruit que l'on cherche à reconstruire y est reproduit sous la forme d'une aire grisée. L'estimation faite par l'invention, après un entraînement sur 7000 signaux aléatoires par valeur de SNR, est représentée par des points. Le spectre du signal bruité est représenté par un trait plein.

L'estimation faite par l'invention est très proche du spectre original avant addition de bruit. L'invention est capable de reproduire fidèlement des détails occultés dans le fond bruité.

L'erreur $\Delta E/E_0$ (en %) sur l'ensemble de 3000 signaux de test, telle qu'évaluée par la métrique d'erreur introduite plus haut, est illustré en ordonnée en figure 5, pour un réseau carré de côté L ($N = L^2$ cavités) pour diverses valeurs de ce paramètre, pour les deux types de mesures de populations optiques (intensités).

L'erreur de l'invention pour deux types de mesures d'intensité (en trait noir en figure 5) est comparée à celle de la transformée de Fourier rapide (FFT) du signal, supposant dans ce dernier cas un échantillonnage idéal du signal bruité, mettant en évidence une meilleure précision de l'invention sur cette tâche dès L = 5.

Ces données sont moyennées sur cinq réalisations aléatoires des paramètres du réseau optique et des coefficients de couplage $v_n$ ; les barres d'erreur verticales en figure 5 encadrent les valeurs extrémales de l'erreur pour ces cinq réalisations.

Cela montre les faibles contraintes imposées par le principe de l'invention sur le degré de contrôle de la fabrication de son élément central. Sur ces mêmes jeux de données (X,Y), un entraînement a été effectué pour un classificateur de la forme $\hat{y}^{(m)} = \sigma(W_2\, x'^{(m)})$, où $\sigma$ désigne la fonction softmax, paramétrée par une seconde matrice de poids $W_2$.

Cet entraînement vise à déterminer la fréquence angulaire à laquelle la puissance du signal est maximale, c'est-à-dire la position du pic le plus élevé du spectre ; son étape d'optimisation a été réalisée par descente stochastique de gradient par l'algorithme Adam.

Les spectres pouvant contenir plusieurs pics, l'on ne cherche pas à réaliser une prédiction directe de la position du pic.

Au lieu de cela, le domaine spectral d'analyse est échantillonné en $N_b$ (ici 50) bins de largeur $\delta\omega = \Delta\omega/N_b$ et l'on cherche à estimer par $\hat{y}_i^{(m)}$ les probabilités de présence $y_i^{(m)}$ du pic maximum dans le i-ième bin.

La position du pic pour le m-ième signal est ensuite obtenue à $\delta\omega$ près, en trouvant la composante maximum du vecteur $\hat{y}^{(m)}$.

Dans les situations ambiguës, e.g. deux pics de hauteur similaire, le vecteur $\hat{y}^{(m)}$ présente deux composantes à peu près équiprobables. Ainsi, l'invention fournit également à l'utilisateur un moyen d'estimer la qualité de la prédiction, d'autant plus élevée que la probabilité associée est proche de l'unité.

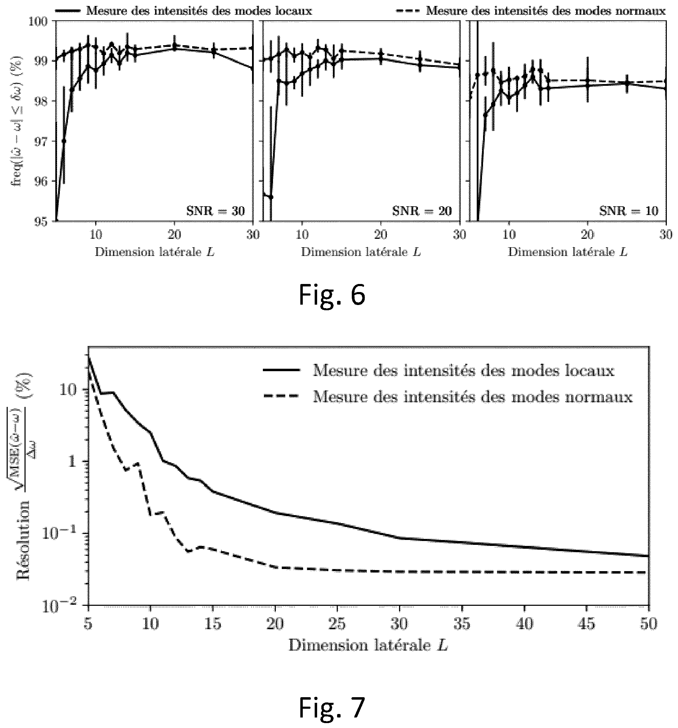

Les résultats de ce second entraînement sont représentés en figure 6, pour trois valeurs du rapport signal sur bruit.

Les diagrammes en figure 6 présentent les résultats obtenus par un traitement selon l'invention, pour une mesure des intensités des modes normaux (en tirets noirs) ou des intensités des modes locaux (en traits continus noirs).

De même qu'en figure 5, ces données sont moyennées sur cinq réalisations aléatoires des paramètres du réseau optique et des coefficients de couplage $v_n$ ; les barres d'erreur verticales en figure 6 encadrent les valeurs extrémales de l'erreur pour ces cinq réalisations.

La possibilité de réaliser une mesure ultra-rapide de la fréquence d'un signal sinusoïdal continu bruité est illustrée en figure 7.

Pour la simulation de cette tâche, des signaux sinusoïdaux bruités (SNR = 20) sont générés avec des fréquences et des phases initiales aléatoires et injectés en entrée du dispositif.

Une transformation simple $\hat{y}^{(m)} = w \cdot x'^{(m)}$, paramétrée par un vecteur de poids w, dûment entraîné, permet d'estimer la fréquence angulaire $y^{(m)}$ du m-ième signal de départ après quelques dizaines de picosecondes.

Les résultats obtenus sont présentés en figure 7, pour une mesure des intensités des modes normaux (courbe en tirets) et pour une mesure locale (courbe en trait plein).

L'invention présente de nombreux avantages.

L'invention permet d'extraire directement l'information spectrale d'un signal radiofréquence analogique, sans jamais avoir à en opérer un prétraitement numérique, une conversion numérique, ni même en réaliser un échantillonnage temporel.

L'invention opère à un taux de traitement (en anglais « throughput ») qui peut être supérieur au gigahertz, avantageusement dizaine de gigahertz, en exploitant le temps caractéristique ultra-court d'un système physique optique et linéaire, un taux sans précédent sur ce type d'opérations.

L'invention est implémentable sous la forme d'un dispositif de photonique intégrée: la charge de calcul repose sur de l'hardware non électronique mais optique.

L'invention se distingue également des méthodes de l'état de l'art, par la possibilité de réaliser plusieurs opérations simultanément à partir d'une seule procédure de mesure.

Aussi peut-elle, au moyen d'un entraînement *ad hoc*, être reprogrammée. Par le protocole d'entraînement proposé sur des signaux bruités, identifié et validé par d'amples campagnes de simulations numériques, les résultats obtenus par l'invention sont résilients à la présence de bruit, davantage qu'une simple FFT.

L'invention ne requiert pas de milieu optique non-linéaire.

Par la linéarité des cavités optiques employées, l'invention ne saurait être assimilée à un dispositif de calcul neuromorphe à réservoir (réservoir computing) standard, duquel elle se distingue par sa simplicité.

L'invention permet de déterminer, en un temps de quelques dizaines de picosecondes, la densité spectrale d'énergie d'un pulse ainsi que sa fréquence dominante, ou la fréquence d'un signal continu.

Ainsi, dans le domaine de l'optique et de l'analyse de signaux radiofréquences, l'invention permet de réaliser les tâches habituellement échues aux spectrographes et monochromateurs.

Dans le domaine des télécommunications, l'invention, par son taux de traitement élevé, permet de décoder des signaux issus de protocoles de frequency-shift keying (FSK), qui, de ce fait, pourraient opérer à des débits plus élevés.

Dans le domaine de l'analyse par radar Doppler pulsé, l'invention permet d'augmenter la vitesse maximum à laquelle des cibles en mouvement peuvent être détectées, limitée dans l'état de l'art par la fréquence de répétition des pulses, choisie suffisamment faible pour en permettre l'analyse.

**Revendications**

1. Dispositif optoélectronique d'extraction de caractéristiques contenues dans le spectre de signaux radiofréquences analogiques continus ou pulsés, bruités, formant un signal analogique d'entrée,

   le dispositif optoélectronique d'extraction étant **caractérisé en ce qu'**il comprend:

   - un module d'entrée générant une onde optique porteuse (1) et effectuant une modulation de cette porteuse optique (1) par le signal d'entrée analogique, par multiplication/mélange, pour former un signal optique modulé;
   - un réseau (5, 21) de cavités optiques linéaires couplées et pompées optiquement par tout ou partie du signal optique modulé, acheminé au réseau (5) par un moyen d'amener de la lumière ;
   - un dispositif (7) de mesure optique directe ou indirecte de quantités mesurées des champs optiques qui sont : des intensités, des amplitudes et/ou des phases des champs optiques au sein des cavités linéaires couplées, ces champs optiques étant induits par le signal optique modulé par le signal analogique d'entrée ;
   - un module de calcul (8) relié au dispositif de mesure optique, effectuant une transformation linéaire sur les quantités mesurées des champs optiques, par multiplication avec une matrice W et addition d'un vecteur de biais b ;

   pour permettre de reconstruire et d'extraire des caractéristiques ciblées contenues dans le spectre du signal d'entrée radiofréquence,
   le module de calcul (8) ayant effectué un apprentissage machine sur des signaux radiofréquences analogiques bruités d'entrainement présentant les mêmes caractéristiques ciblées afin de déterminer les paramètres W et b.

2. Dispositif selon la revendication 1, **caractérisé en ce que** le dispositif optoélectronique extrait les caractéristiques sans faire usage d'unité optique non linéaire entre le réseau de cavités optiques linéaires et le dispositif de mesure, ni échantillonnage du signal analogique d'entrée.

3. Dispositif selon l'une des revendications 1 à 2, **caractérisé en ce que** le dispositif optoélectronique extrait les caractéristiques à une cadence supérieure au gigahertz.

4. Dispositif selon l'une des revendications 1 à 3, **caractérisé en ce que** les cavités optiques linéaires sont couplées par des couplages fixes.

5. Dispositif selon l'une des revendications 1 à 3, **caractérisé en ce que** les cavités optiques linéaires sont couplées de façon aléatoire.

6. Dispositif selon l'une des revendications 1 à 4, **caractérisé en ce que** les cavités optiques linéaires sont réalisées sous la forme de structures nanométriques/micrométriques gravées dans un matériau semiconducteur ou diélectrique, arrangées en un réseau de cavités optiques de géométrie planaire, avec des couplages directs entre sites plus proches voisins, ou indirects entre sites arbitrairement éloignés.

**7.** Dispositif selon l'une des revendications 1 à 5, **caractérisé en ce que** le réseau de cavités optiques est implémenté sur une puce photonique.

**8.** Dispositif selon la revendication 7, **caractérisé en ce que** la puce photonique comprend des résonateurs en anneaux latéralement couplés, ou un réseau de micro ou nano-piliers, ou un réseau planaire de cavités optiques en forme de disque, ou un réseau planaire de cavités fondées sur des cristaux photoniques.

**9.** Dispositif selon l'une des revendications 7 ou 8, **caractérisé en ce que** la puce photonique est en silicium et/ou dioxyde de silicium.

**10.** Dispositif selon l'une quelconque des revendications 1 à 5, **caractérisé en ce que** le réseau de cavités optiques est un ensemble désordonné ou ordonné de diffuseurs optiques linéaires, formant un matériau dense ou un milieu dilué diffusant.

**11.** Dispositif selon l'une quelconque des revendications 1 à 10, **caractérisé en ce que** le module d'entrée effectuant la modulation de la porteuse optique par le signal d'entrée analogique comprend un modulateur (2) électro-optique.

**12.** Dispositif selon l'une quelconque des revendications 1 à 11, **caractérisé en ce que** le module d'entrée génère plusieurs ondes porteuses optiques différentes modulées par le signal d'entrée.

**13.** Dispositif selon l'une quelconque des revendications 1 à 12, **caractérisé en ce que** les signaux d'entrée radiofréquences analogiques ont une fréquence limitée par le module d'entrée.

**14.** Dispositif selon l'une quelconque des revendications 1 à 13, **caractérisé en ce que** le réseau (21) de cavités optiques présente au moins $5 \times 5$ cavités optiques.

**15.** Dispositif selon l'une quelconque des revendications 1 à 14, **caractérisé en ce que** la matrice W est entrainée pour extraire les caractéristiques ciblées suivantes :

- la densité spectrale, c'est-à-dire le spectre, du signal d'entrée
- la fréquence d'un pic identifié dans ce spectre,
- la forme spectrale d'un pulse, par exemple gaussienne ou lorentzienne.

**16.** Dispositif selon l'une quelconque des revendications 1 à 15, **caractérisé en ce qu'**il comprend un démultiplexeur optique séparant les signaux émis par les différents modes normaux du réseau de cavités, de longueur d'onde différente.

**17.** Dispositif selon l'une quelconque des revendications 1 à 16, **caractérisé en ce que** le module effectuant la transformation linéaire comprend une unité électronique de calcul arithmétique, formant un circuit logique programmable.

**18.** Dispositif selon la revendication 17, **caractérisé en ce que** le circuit logique programmable est un réseau de portes programmables *in situ.*

**19.** Dispositif selon l'une quelconque des revendications 1 à 18, **caractérisé en ce que** le dispositif de mesure optique des quantités associées aux champs des cavités optiques comprend une caméra disposée en regard de la structure du réseau de cavités, et est apte à mesurer l'intensité, l'amplitude et/ou la phase de la lumière rayonnée par chaque cavité.

**20.** Dispositif selon l'une quelconque des revendications 1 à 19, **caractérisé en ce que** le dispositif de mesure optique des quantités associées aux champs des cavités optiques comprend des guides d'ondes couplés en champ proche aux cavités optiques linéaires, et est apte à mesurer l'intensité, l'amplitude et/ou la phase de la lumière émise aux fréquences propres du réseau.

**21.** Dispositif optoélectronique d'extraction de caractéristiques contenues dans le spectre de signaux radiofréquences analogiques continus ou pulsés, bruités, formant un signal analogique d'entrée, le dispositif optoélectronique d'extraction étant **caractérisé en ce qu'**il comprend:

- un module d'entrée générant une onde optique porteuse et effectuant une modulation de cette porteuse optique par le signal d'entrée analogique, par multiplication/mélange, pour former un signal optique modulé;
- un réseau de cavités optiques linéaires couplées et pompées optiquement par tout ou partie du signal optique modulé, acheminé au réseau par un moyen d'amener de la lumière ;
- un module d'optique linéaire en aval du réseau de cavités linéaires, permettant d'obtenir des superpositions linéaires à partir de champs optiques rayonnées par les cavités du réseau, le m-ième signal ainsi généré s'exprimant sous la forme d'une somme pondérée de ces champs, dont la matrice de poids W et le vecteur de biais b sont issus d'un processus d'apprentissage machine sur des signaux radiofréquences analogues bruités d'entraînement ;
- un dispositif de mesure optique des intensités, des amplitudes et/ou des phases des N' superpositions linéaires des champs optiques rayonnés par les cavités linéaires couplées.

22. Dispositif selon l'une quelconque des revendications 1 à 21, **caractérisé en ce que** la matrice de poids W est une matrice de nombres complexes.

23. Dispositif selon la revendication 21, **caractérisé en ce que** le module d'optique linéaire en aval du réseau de cavités comprend un dispositif d'optique adaptative agissant sur l'amplitude et/ou la phase des champs rayonnés.

24. Dispositif selon la revendication 23, **caractérisé en ce que** le dispositif d'optique adaptative comprend un modulateur spatial de lumière.

25. Dispositif selon la revendication 23 ou 24, **caractérisé en ce que** le dispositif d'optique adaptative comprend une matrice de micro-miroirs.

26. Dispositif selon la revendication 21, **caractérisé en ce que** le module d'optique linéaire en aval du réseau de cavités comprend un dispositif d'optique fibrée ou intégrée.

27. Procédé d'extraction de caractéristiques contenues dans le spectre de signaux radiofréquences analogiques continus ou pulsés, bruités, formant un signal analogique d'entrée, le procédé d'extraction utilisant le dispositif selon l'une des revendications 1 à 20, et comprenant :

   - une étape de mélange/multiplication du signal $s^{(m)}(t)$ d'entrée radiofréquence par modulation d'une onde porteuse optique $c(t)$, pour former un signal optique modulé $S^{(m)}(t)$;
   - une étape de couplage et pompage optique d'un réseau (21) de cavités optiques linéaires par tout ou partie du signal optique modulé $S^{(m)}(t)$;
   - une étape de mesure des intensités, amplitudes et/ou phases des champs optiques des cavités ;
   - une étape de transformation linéaire sur les quantités mesurées associées aux champs ;
   - une étape d'apprentissage machine pour la transformation linéaire.

28. Procédé selon la revendication 27, **caractérisé en ce que** l'étape de mélange/multiplication est effectuée par un module constitué d'un oscillateur local optique générant l'onde porteuse optique $c(t)$, et un modulateur de signal générant un signal $S^{(m)}(t)$ par modulation en phase ou en amplitude de la porteuse optique en fonction du signal d'entrée radiofréquence $s^{(m)}(t)$.

29. Procédé selon la revendication 27 ou 28, **caractérisé en ce que** la fréquence angulaire $\omega_p$ de l'onde optique porteuse $c(t) \sim \exp(-i\omega_p t)$ est choisie telle que $\omega_p = \omega - \omega_0$, où $\omega$ désigne le centre du spectre du réseau de cavités optiques, et $\omega_0$ le centre de la gamme spectrale radiofréquence sur laquelle l'analyse des signaux d'entrée est réalisée.

30. Procédé selon la revendication 29, **caractérisé en ce que** la largeur $\Delta\omega$ de la gamme spectrale d'analyse est égale à la largeur spectrale du réseau (21) de cavité.

31. Procédé selon l'une quelconque des revendications 27 à 30, **caractérisé en ce que** l'amplitude du pompage effectif des cavités individuelles constituant le réseau (21) est proportionnelle à l'amplitude du signal optique acheminé jusqu'aux cavités du réseau.

32. Procédé selon l'une quelconque des revendications 27 à 31, **caractérisé en ce que** l'étape de mesure des quantités physiques associées aux champs des cavités optiques fournit ces quantités en format numérique sous la forme d'un vecteur de nombres $x^{(m)}$, où m est l'indice associé au m-ième signal d'entrée $s^{(m)}(t)$ à analyser.

**33.** Procédé selon la revendication 32, **caractérisé en ce que** l'étape de transformation linéaire effectue des transformations affines du vecteur de nombres $x^{(m)}$, retournant des vecteurs $(\hat{y}_1^{(m)},...,\hat{y}_K^{(m)})$ de la forme $\hat{y}_i^{(m)} = W_i \cdot x^{(m)} + b_i$.

**34.** Procédé selon la revendication 33, **caractérisé en ce que** l'étape d'apprentissage machine est effectuée pour ajuster les paramètres $(W_i, b_i)$ des transformations affines, un ensemble de $N_{train}$ signaux d'entraînement $s^{(m)}(t)$ $(m=1,...,N_{train})$, dont K caractéristiques d'intérêt descriptibles par une série de vecteurs $(y_1^{(m)},...,y_K^{(m)})$ sont connues générant $N_{train}$ vecteurs de nombres $(x^{(1)},...,x^{(Ntrain)})$, chaque vecteur étant transformé afin d'obtenir une série de prédictions $(\hat{y}_1^{(m)},...,\hat{y}_K^{(m)})$ associées au caractéristiques ciblées $(y_1^{(m)},...,y_K^{(m)})$.

**35.** Procédé selon la revendication 34, **caractérisé en ce que** les paramètres $(W_i, b_i)$ sont ajustés de sorte que l'erreur $E_{train}$ entre les prédictions $(\hat{y}_1^{(m)},...,\hat{y}_K^{(m)})$ et les quantités ciblées $(y_1^{(m)},...,y_K^{(m)})$ soit minimisée.

**36.** Procédé selon la revendication 35, **caractérisé en ce qu'**une fois les poids $(W_i, b_i)$ fixés à leurs valeurs optimum, la qualité de la prédiction est évaluée sur une série de $N_{test}$ signaux de test $s^{(m)}(t)$ aux caractéristiques ciblées connues à l'avance.

**37.** Procédé d'extraction de caractéristiques contenues dans le spectre de signaux radiofréquences analogiques continus ou pulsés, bruités, formant un signal analogique d'entrée, le procédé d'extraction utilisant le dispositif selon l'une des revendications 21 à 26, et comprenant :

- une étape de mélange/multiplication du signal d'entrée radiofréquence par modulation d'une onde porteuse optique, pour former un signal optique modulé ;
- une étape de couplage et pompage optique d'un réseau de cavités optiques linéaires par tout ou partie du signal optique modulé ;
- une étape de superposition linéaire des champs optiques rayonnés par les cavités du réseau ;
- une étape de mesure optique des intensités, des amplitudes et/ou des phases des superpositions linéaires des champs optiques rayonnés par les cavités linéaires couplées, chaque superposition linéaire des champs optiques rayonné par les cavités du réseau s'exprimant sous la forme d'une somme pondérée de ces champs, dont la matrice de poids W et le vecteur de biais sont issus d'un apprentissage machine sur des signaux radiofréquences analogiques bruités d'entraînement.

**38.** Procédé selon la revendication 37, **caractérisé en ce que** la matrice de poids W est une matrice de nombres complexes.

**39.** Procédé selon la revendication 37 ou 38, **caractérisé en ce que** la génération des superpositions linéaires est effectuée après extraction de N composantes de longueurs d'onde distinctes à partir du champ optique collecté.

**40.** Utilisation d'un dispositif selon l'une quelconque des revendications 1 à 26, à la détermination de la densité spectrale d'un signal radiofréquence.

**41.** Utilisation d'un dispositif selon l'une quelconque des revendications 1 à 26, à la détermination de la fréquence angulaire d'un maximum ciblé dans le spectre d'un signal radiofréquence.

**42.** Utilisation d'un dispositif selon l'une quelconque des revendications 1 à 26, à la détermination de la fréquence d'un signal harmonique.

**43.** Utilisation d'un dispositif selon l'une des revendications 1 à 26, dans les télécommunications, par exemple pour décoder des signaux issus de protocole FSK.

**44.** Utilisation d'un dispositif selon l'une des revendications 1 à 26, pour l'analyse radar Doppler pulsé.

**45.** Application du procédé selon l'une quelconque des revendications 27 à 36, ou 37 à 39, à la détermination de la densité spectrale d'énergie et/ou la fréquence dominante d'un pulse radiofréquence.

**Patentansprüche**

**1.** Optoelektronische Vorrichtung zum Extrahieren von Merkmalen, die im Spektrum von verrauschten kontinuierlichen oder gepulsten analogen Funkfrequenzsignalen enthalten sind, die ein analoges Eingangssignal bilden, wobei die optoelektronische Vorrichtung zum Extrahieren **dadurch gekennzeichnet ist, dass** sie umfasst:

- ein Eingangsmodul, das eine optische Trägerwelle (1) erzeugt und eine Modulation dieses optischen Trägers (1) durch das analoge Eingangssignal durchführt, durch Multiplikation/Mischen, um ein moduliertes optisches Signal zu bilden;
- ein Netzwerk (5, 21) von linearen optischen Hohlräumen, die optisch durch das gesamte oder einen Teil des modulierten optischen Signals gekoppelt und gepumpt werden, das über ein Mittel zur Zuführung von Licht zum Netzwerk (5) weitergeleitet wird;
- eine Vorrichtung (7) zur direkten oder indirekten optischen Messung der gemessenen Mengen der optischen Felder, die sind: Intensitäten, Amplituden und/oder Phasen der optischen Felder innerhalb der gekoppelten linearen Hohlräume, wobei diese optischen Felder durch das durch das analoge Eingangssignal modulierte optische Signal induziert werden;
- ein Rechenmodul (8), das an die optische Messvorrichtung angeschlossen ist, und eine lineare Transformation der gemessenen Mengen der optischen Felder durchführt, durch Multiplikation mit einer Matrix W und Addition eines Vektors mit Bias b;

um die Rekonstruktion und das Extrahieren der Zielmerkmale, die im Spektrum des Funkfrequenz-Eingangssignals enthalten sind, zu ermöglichen, wobei das Rechenmodul (8) ein maschinelles Lernen an den verrauschten analogen Funkfrequenzsignalen zum Training durchgeführt hat, die die selben Zielmerkmale aufweisen, um die Parameter W und b zu bestimmen.

2. Vorrichtung nach Anspruch 1, **dadurch gekennzeichnet, dass** die optoelektronische Vorrichtung die Merkmale extrahiert, ohne eine nichtlineare optische Einheit zwischen dem Netzwerk der linearen optischen Hohlräume und der Messvorrichtung zu verwenden, oder eine Abtastung des analogen Eingangssignals.

3. Vorrichtung nach einem der Ansprüche 1 bis 2, **dadurch gekennzeichnet, dass** die optoelektronische Vorrichtung die Merkmale mit einer Rate extrahiert, die über dem Gigahertz liegt.

4. Vorrichtung nach einem der Ansprüche 1 bis 3, **dadurch gekennzeichnet, dass** die linearen optischen Hohlräume durch feste Kopplungen gekoppelt sind.

5. Vorrichtung nach einem der Ansprüche 1 bis 3, **dadurch gekennzeichnet, dass** die linearen optischen Hohlräume willkürlich gekoppelt sind.

6. Vorrichtung nach einem der Ansprüche 1 bis 4, **dadurch gekennzeichnet, dass** die linearen optischen Hohlräume in Form von nanometrischen/mikrometrischen Strukturen realisiert sind, die in ein Halbleiter- oder Dielektrizitätsmaterial geätzt und in einem Netzwerk der optischen Hohlräume mit planarer Geometrie positioniert sind, mit direkten Kopplungen zwischen nahegelegenen benachbarten Stellen oder mit indirekten zwischen Stellen, die beliebig entfernt sind.

7. Vorrichtung nach einem der Ansprüche 1 bis 5, **dadurch gekennzeichnet, dass** das Netzwerk der optischen Hohlräume auf einem Photonik-Chip implementiert ist.

8. Vorrichtung nach Anspruch 7, **dadurch gekennzeichnet, dass** der Photonik-Chip seitlich gekoppelte Ringresonatoren umfasst oder ein Netzwerk von Mikro- oder Nanosäulen oder ein planares Netzwerk von scheibenförmigen optischen Hohlräumen oder ein planares Netzwerk von Hohlräumen auf Basis von Photonik-Kristallen.

9. Vorrichtung nach einem der Ansprüche 7 oder 8, **dadurch gekennzeichnet, dass** der Photonik-Chip aus Silizium und/oder Siliziumdioxid besteht.

10. Vorrichtung nach einem der Ansprüche 1 bis 5, **dadurch gekennzeichnet, dass** das Netzwerk der optischen Hohlräume eine nicht geordnete oder geordnete Gruppe von linearen optischen Diffusoren ist, die ein dichtes Material oder ein verdünntes streuendes Medium bilden.

11. Vorrichtung nach einem der Ansprüche 1 bis 10, **dadurch gekennzeichnet, dass** das Eingangsmodul, das die Modulation des optischen Trägers durch das analoge Eingangssignal durchführt, einen elektrooptischen Modulator (2) umfasst.

**12.** Vorrichtung nach einem der Ansprüche 1 bis 11, **dadurch gekennzeichnet, dass** das Eingangsmodul mehrere unterschiedliche optische Trägerwellen erzeugt, die durch das Eingangssignal moduliert werden.

**13.** Vorrichtung nach einem der Ansprüche 1 bis 12, **dadurch gekennzeichnet, dass** die analogen Funkfrequenz-Eingangssignale eine durch das Eingangsmodul begrenzte Frequenz haben.

**14.** Vorrichtung nach einem der Ansprüche 1 bis 13, **dadurch gekennzeichnet, dass** das Netzwerk (21) der optischen Hohlräume mindestens 5x5 optische Hohlräume aufweist.

**15.** Vorrichtung nach einem der Ansprüche 1 bis 14, **dadurch gekennzeichnet, dass** die Matrix W zum Extrahieren folgender Zielmerkmale trainiert wird:

- die spektrale Dichte, d. h. das Spektrum, des Eingangssignals,
- die Frequenz eines in diesem Spektrum identifizierten Peaks,
- die spektrale Form eines Impulses, beispielsweise gaußischer oder lorentzischer.

**16.** Vorrichtung nach einem der Ansprüche 1 bis 15, **dadurch gekennzeichnet, dass** sie einen optischen Demultiplexer umfasst, der die Signale, die von den verschiedenen normalen Modi des Netzwerkes der Hohlräume emittiert wurden, von den unterschiedlichen Wellenlängen trennt.

**17.** Vorrichtung nach einem der Ansprüche 1 bis 16, **dadurch gekennzeichnet, dass** das Modul, das die lineare Transformation durchführt, eine arithmetische Recheneinheit umfasst, die eine programmierbare Logikschaltung bildet.

**18.** Vorrichtung nach Anspruch 17, **dadurch gekennzeichnet, dass** die programmierbare Logikschaltung ein *In-System*-Programmierungs-Gatternetz ist.

**19.** Vorrichtung nach einem der Ansprüche 1 bis 18, **dadurch gekennzeichnet, dass** die Vorrichtung zur optischen Messung der mit den Feldern der optischen Hohlräume assoziierten Mengen eine gegenüber der Struktur des Netzwerkes der Hohlräume angeordnete Kamera umfasst und in der Lage ist, die Intensität, Amplitude und/oder Phase des von jedem Hohlraum abgestrahlten Lichts zu messen.

**20.** Vorrichtung nach einem der Ansprüche 1 bis 19, **dadurch gekennzeichnet, dass** die Vorrichtung zur optischen Messung der mit den Feldern der optischen Hohlräume assoziierten Mengen Wellenleiter umfasst, die im Nahfeld an die linearen optischen Hohlräume gekoppelt sind, und in der Lage ist, die Intensität, Amplitude und/oder Phase des in den Eigenfrequenzen des Netzwerkes emittierten Lichts zu messen.

**21.** Optoelektronische Vorrichtung zum Extrahieren von Merkmalen, die im Spektrum von verrauschten kontinuierlichen oder gepulsten analogen Funkfrequenzsignalen enthalten sind, die ein analoges Eingangssignal bilden, wobei die optoelektronische Vorrichtung zum Extrahieren **dadurch gekennzeichnet ist, dass** sie umfasst:

- ein Eingangsmodul, das eine optische Trägerwelle erzeugt und eine Modulation dieses optischen Trägers durch das analoge Eingangssignal durchführt, durch Multiplikation/Mischen, um ein moduliertes optisches Signal zu bilden;
- ein Netzwerk von linearen optischen Hohlräumen, die optisch durch das gesamte oder einen Teil des modulierten optischen Signals gekoppelt und gepumpt werden, das über ein Mittel zur Zuführung von Licht zum Netzwerk weitergeleitet wird;
- ein lineares Optikmodul, dem Netzwerk von linearen Hohlräumen nachgeschaltet, das es ermöglicht, lineare Überlagerungen ausgehend von optischen Feldern zu erhalten, die von den Hohlräumen des Netzwerkes abgestrahlt werden, wobei das so erzeugte m-te Signal in Form einer gewichteten Summe dieser Felder ausgedrückt wird, deren Gewichtsmatrix W und Vektor mit Bias b aus einem Prozess des maschinellen Lernens auf verrauschten analogen Funkfrequenzsignalen zum Training hervorgegangen sind;
- eine Vorrichtung zur optischen Messung der Intensitäten, Amplituden und/oder Phasen der N' linearen Überlagerungen der optischen Felder, die von den gekoppelten linearen Hohlräumen abgestrahlt werden.

**22.** Vorrichtung nach einem der Ansprüche 1 bis 21, **dadurch gekennzeichnet, dass** die Gewichtsmatrix W eine Matrix von komplexen Zahlen ist.

**23.** Vorrichtung nach Anspruch 21, **dadurch gekennzeichnet, dass** das dem Netzwerk der Hohlräume nachgeschaltete lineare Optikmodul eine adaptive optische Vorrichtung umfasst, die auf die Amplitude und/oder Phase der abgestrahlten Felder wirkt.

**24.** Vorrichtung nach Anspruch 23, **dadurch gekennzeichnet, dass** die adaptive optische Vorrichtung einen räumlichen Modulator für Licht umfasst.

**25.** Vorrichtung nach Anspruch 23 oder 24, **dadurch gekennzeichnet, dass** die adaptive optische Vorrichtung eine Matrix von Mikrospiegeln umfasst.

**26.** Vorrichtung nach Anspruch 21, **dadurch gekennzeichnet, dass** das dem Netzwerk der Hohlräume nachgeschaltete lineare Optikmodul eine faserförmige oder integrierte optische Vorrichtung umfasst.

**27.** Verfahren zum Extrahieren von Merkmalen, die im Spektrum von verrauschten kontinuierlichen oder gepulsten analogen Funkfrequenzsignalen enthalten sind, die ein analoges Eingangssignal bilden, wobei das Extrahierungsverfahren die Vorrichtung nach einem der Ansprüche 1 bis 20 verwendet, und umfasst:

- einen Schritt des Mischens/Multiplizierens des Funkfrequenz-Eingangssignals $s^{(m)}(t)$ durch Modulation einer optischen Trägerwelle $c(t)$, um ein moduliertes optisches Signal $S^{(m)}(t)$ zu bilden;
- einen Schritt der optischen Kopplung und des Pumpens eines Netzwerkes (21) von linearen optischen Hohlräumen durch das gesamte oder einen Teil des modulierten optischen Signals $S^{(m)}(t)$;
- einen Schritt zur Messung der Intensitäten, Amplituden und/oder Phasen der optischen Felder der Hohlräume;
- einen Schritt der linearen Transformation auf die gemessenen Mengen, die mit den Feldern assoziiert sind;
- einen Schritt des maschinellen Lernens für die lineare Transformation.

**28.** Verfahren nach Anspruch 27, **dadurch gekennzeichnet, dass** der Schritt des Mischens/Multiplizierens durch ein Modul durchgeführt wird, das aus einem lokalen optischen Oszillator gemacht ist, der die optische Trägerwelle $c(t)$ erzeugt, und einem Signalmodulator, der ein Signal $S^{(m)}(t)$ erzeugt durch Phasen- oder Amplitudenmodulation des optischen Trägers in Abhängigkeit vom Funkfrequenz-Eingangssignal $s^{(m)}(t)$.

**29.** Verfahren nach Anspruch 27 oder 28, **dadurch gekennzeichnet, dass** die Winkelfrequenz $\omega_p$ der optischen Trägerwelle $c(t) \sim \exp(-i\omega_p t)$ so gewählt ist, dass $\omega_p = \omega - \omega_0$, wobei w das Zentrum des Spektrums des Netzwerkes der optischen Hohlräume ist und $\omega_0$ für das Zentrum des Funkfrequenz-Spektrumbereichs steht, auf dem die Analyse der Eingangssignale realisiert wird.

**30.** Verfahren nach Anspruch 29, **dadurch gekennzeichnet, dass** die Breite $\Delta\omega$ des Analysespektrumbereichs gleich der Spektrumsbreite des Netzwerkes (21) des Hohlraums ist.

**31.** Verfahren nach einem der Ansprüche 27 bis 30, **dadurch gekennzeichnet, dass** die Amplitude des effektiven Pumpens der einzelnen Hohlräume, aus denen das Netzwerk (21) gemacht ist, proportional zur Amplitude des optischen Signals ist, das bis zu den Hohlräumen des Netzwerkes weitergeleitet wird.

**32.** Verfahren nach einem der Ansprüche 27 bis 31, **dadurch gekennzeichnet, dass** der Schritt der Messung der mit den Feldern der optischen Hohlräume assoziierten physikalischen Mengen diese Mengen in numerischem Format in Form eines Zahlenvektors $x^{(m)}$ bereitstellt, wobei m der Index ist, der mit dem m-ten zu analysierenden Eingangssignal $s^{(m)}(t)$ assoziiert ist.

**33.** Verfahren nach Anspruch 32, **dadurch gekennzeichnet, dass** der Schritt der linearen Transformation affine Transformationen des Zahlenvektors $x^{(m)}$ durchführt, und die Vektoren $(\hat{y}_1^{(m)}, ..., \hat{y}_K^{(m)})$ der Form $\hat{y}_1^{(m)} = W_i \cdot X^{(m)} + b_i$ zurückgibt.

**34.** Verfahren nach Anspruch 33, **dadurch gekennzeichnet, dass** der Schritt des maschinellen Lernens durchgeführt wird, um die Parameter $(W_i, b_i)$ der affinen Transformationen anzupassen, eine Gruppe von $N_{train}$ Trainingssignalen $s^{(m)}(t)$ ($m=1,...,N_{train}$), wobei K von Interessenmerkmalen, die durch eine Reihe von Vektoren $(y_1^{(m)}, ..., y_K^{(m)})$ beschreibbar sind, bekannt sind, und $N_{train}$ Zahlenvektoren $(X^{(1)}, ..., X^{(Ntrain)})$ erzeugen, wobei jeder Vektor transformiert wird, um eine Reihe von Vorhersagen $(\hat{y}1^{(m)}, ..., \hat{y}_K^{(m)})$ zu erhalten, die mit den Zielmerkmalen $(y_1^{(m)}, ..., y_K^{(m)})$ assoziiert sind.

**35.** Verfahren nach Anspruch 34, **dadurch gekennzeichnet, dass** die Parameter ($W_i$, $b_i$) so angepasst werden, dass der Fehler $E_{train}$ zwischen den Vorhersagen ($\hat{y}_1^{(m)}$,...,$\hat{y}_K^{(m)}$) und den Zielmengen ($y_1^{(m)}$,...,$y_K^{(m)}$) minimiert wird.

**36.** Verfahren nach Anspruch 35, **dadurch gekennzeichnet, dass** nachdem die Gewichte ($W_i$, $b_i$) auf ihre optimalen Werte festgelegt sind, die Qualität der Vorhersage an einer Reihe von $N_{test}$ Testsignalen $s^{(m)}(t)$ mit vorher bekannten Zielmerkmalen bewertet wird.

**37.** Verfahren zum Extrahieren von Merkmalen, die im Spektrum von verrauschten kontinuierlichen oder gepulsten analogen Funkfrequenzsignalen enthalten sind, die ein analoges Eingangssignal bilden, wobei das Extrahierungsverfahren die Vorrichtung nach einem der Ansprüche 21 bis 26 verwendet, und umfasst:

- einen Schritt des Mischens/Multiplizierens des Funkfrequenz-Eingangssignals durch Modulation einer optischen Trägerwelle, um ein moduliertes optisches Signal zu bilden;
- einen Schritt der optischen Kopplung und des Pumpens eines Netzwerkes von linearen optischen Hohlräumen durch das gesamte oder einen Teil des modulierten optischen Signals;
- einen Schritt der linearen Überlagerung der optischen Felder, die von den Hohlräumen des Netzwerks abgestrahlt werden;
- einen Schritt zur optischen Messung der Intensitäten, Amplituden und/oder Phasen der linearen Überlagerungen der optischen Felder, die von den gekoppelten linearen Hohlräumen abgestrahlt werden, wobei jede lineare Überlagerung der optischen Felder, die von den Hohlräumen des Netzwerkes abgestrahlt werden, in Form einer gewichteten Summe dieser Felder ausgedrückt wird, deren Gewichtsmatrix W und Vektor mit Bias aus einem maschinellen Lernen auf verrauschten analogen Funkfrequenzsignalen zum Training hervorgegangen sind.

**38.** Verfahren nach Anspruch 37, **dadurch gekennzeichnet, dass** die Gewichtsmatrix W eine Matrix von komplexen Zahlen ist.

**39.** Verfahren nach Anspruch 37 oder 38, **dadurch gekennzeichnet, dass** die Erzeugung der linearen Überlagerungen nach dem Extrahieren von N Komponenten unterschiedlicher Wellenlängen ausgehend vom erfassten optischen Feld durchgeführt wird.

**40.** Verwendung einer Vorrichtung nach einem der Ansprüche 1 bis 26 zur Bestimmung der spektralen Dichte eines Funkfrequenzsignals.

**41.** Verwendung einer Vorrichtung nach einem der Ansprüche 1 bis 26, zur Bestimmung der Winkelfrequenz eines angestrebten Maximums im Spektrum eines Funkfrequenzsignals.

**42.** Verwendung einer Vorrichtung nach einem der Ansprüche 1 bis 26 zur Bestimmung der Frequenz eines harmonischen Signals.

**43.** Verwendung einer Vorrichtung nach einem der Ansprüche 1 bis 26, in der Telekommunikation, beispielsweise zum Decodieren von Signalen, die aus dem FSK-Protokoll hervorgegangen sind.

**44.** Verwendung einer Vorrichtung nach einem der Ansprüche 1 bis 26, für die Puls-Doppler-Radaranalyse.

**45.** Anwendung des Verfahrens nach einem der Ansprüche 27 bis 36 oder 37 bis 39 zur Bestimmung der spektralen Energiedichte und/oder der vorherrschenden Frequenz eines Funkfrequenzimpulses.

**Claims**

**1.** An optoelectronic device for extracting features contained in the spectrum of noised, continuous or pulsed analogue radiofrequency signals, forming an analogue input signal, the optoelectronic extraction device being **characterised in that** it comprises:

- an input module generating an optical carrier wave (1) and performing modulation of this optical carrier (1) by the analogue input signal, by multiplication/mixing, to form a modulated optical signal;
- an array (5, 21) of linear optical cavities coupled and pumped optically by all or part of the modulated optical signal, routed to the array (5) by a means for feeding light;

- a device (7) for directly or indirectly optically measuring measured amounts of optical fields which are: intensities, amplitudes and/or phases of optical fields within coupled linear cavities, these optical fields being induced by the modulated optical signal by the analogue input signal;
- a computation module (8) connected to the optical measurement device, performing a linear transformation on the measured amounts of the optical fields, by multiplication with a matrix W and addition of a bias vector b;

to allow reconstructing and extracting targeted features contained in the spectrum of the radiofrequency input signal, the computation module (8) having performed machine learning on training noised analogue radiofrequency signals having the same targeted features in order to determine the parameters W and b.

2. The device according to claim 1, wherein the optoelectronic device extracts the features without using a non-linear optical unit between the array of linear optical cavities and the measurement device, nor sampling the analogue input signal.

3. The device according to one of claims 1 to 2, **characterised in that** the optoelectronic device extracts the features at a rate greater than one gigahertz.

4. The device according to one of claims 1 to 3, **characterised in that** the linear optical cavities are coupled with fixed couplings.

5. The device according to one of claims 1 to 3, **characterised in that** the linear optical cavities are randomly coupled.

6. The device according to one of claims 1 to 4, **characterised in that** the linear optical cavities are made in the form of nanometre/micrometre size structures etched in a semiconductor or dielectric material, arranged in an array of optical cavities of planar geometry, with direct couplings between nearest neighbouring sites, or indirect couplings between arbitrarily distant sites.

7. The device according to one of claims 1 to 5, **characterised in that** the array of optical cavities is implemented on a photon chip.

8. The device according to claim 7, **characterised in that** the photon chip comprises laterally coupled ring resonators, or an array of micro or nano-pillars, or a planar array of disc-shaped optical cavities, or a planar array of cavities based on photon crystals.

9. The device according to one of claims 7 or 8, **characterised in that** the photon chip is made of silicon and/or silicon dioxide.

10. The device according to any of claims 1 to 5, **characterised in that** the array of optical cavities is a disordered or ordered assembly of linear optical diffusers, forming a dense material or diffusing diluted medium.

11. The device according to any of claims 1 to 10, **characterised in that** the input module performing modulation of the optical carrier by the analogue input signal comprises an electro-optical modulator (2).

12. The device according to any of claims 1 to 11, **characterised in that** the input module generates several different optical carrier waves modulated by the input signal.

13. The device according to any of claims 1 to 12, **characterised in that** the analogue radiofrequency input signals have a frequency limited by the input module.

14. The device according to any of claims 1 to 13, **characterised in that** the array (21) of optical cavities has at least 5x5 optical cavities.

15. The device according to any of claims 1 to 14, **characterised in that** the matrix W is trained to extract the following targeted features:

- the spectral density, that is the spectrum, of the input signal
- the frequency of a peak identified in this spectrum,

- the spectral shape of a pulse, for example Gaussian or Lorentzian.

16. The device according to any of claims 1 to 15, **characterised in that** it comprises an optical demultiplexer separating the signals emitted by the different normal modes of the array of cavities, of different wavelength.

17. The device according to any of claims 1 to 16, **characterised in that** the module performing linear transformation comprises an electronic arithmetic computation unit, forming a programmable logic circuit.

18. The device according to claim 17, **characterised in that** the programmable logic circuit is an *in situ* programmable gate array.

19. The device according to any of claims 1 to 18, **characterised in that** the device for optically measuring amounts associated with the fields of the optical cavities comprises a camera disposed facing the structure of the array of cavities, and is capable of measuring the intensity, amplitude and/or phase of the light radiated by each cavity.

20. The device according to any of claims 1 to 19, **characterised in that** the device for optically measuring amounts associated with the fields of the optical cavities comprises waveguides coupled in the near field to the linear optical cavities, and is capable of measuring the intensity, amplitude and/or phase of light emitted at the eigen frequencies of the array.

21. An optoelectronic device for extracting features contained in the spectrum of continuous or pulsed, noised analogue radiofrequency signals forming an analogue input signal, the optoelectronic extraction device comprising:

   - an input module generating an optical carrier wave and performing modulation of this optical carrier by the analogue input signal, by multiplication/mixing, to form a modulated optical signal;
   - an array of linear optical cavities coupled and pumped optically by all or part of the modulated optical signal, routed to the array by a means for feeding light;
   - a linear optics module downstream of the array of linear cavities, making it possible to obtain linear superpositions from optical fields radiated by the cavities of the array, the m-th signal thus generated being expressed as a weighted sum of these fields, the weight matrix W and the bias vector b of which are derived from a machine learning process on training noised analogue radiofrequency signals;
   - a device for optically measuring the intensities, amplitudes and/or phases of the N' linear superpositions of the optical fields radiated by the coupled linear cavities.

22. The device according to any of claims 1 to 21, **characterised in that** the weight matrix W is a complex number matrix.

23. The device according to claim 21, **characterised in that** the linear optics module downstream of the array of cavities comprises an adaptive optics device acting on the amplitude and/or phase of the radiated fields.

24. The device according to claim 23, **characterised in that** the adaptive optics device comprises a spatial light modulator.

25. The device according to claim 23 or 24, **characterised in that** the adaptive optics device comprises a digital micromirror device.

26. The device according to claim 21, **characterised in that** the linear optics module downstream of the array of cavities comprises a fibre optics or integrated optics device.

27. A method for extracting features contained in the spectrum of continuous or pulsed, noised, analogue radiofrequency signals forming an analogue input signal, the extraction method using the device according to one of claims 1 to 20, and comprising:

   - a step of mixing/multiplying the radiofrequency input signal $s^{(m)}(t)$ by modulation of an optical carrier wave $c(t)$, to form a modulated optical signal $S^{(m)}(t)$;
   - a step of optically coupling and pumping an array (21) of linear optical cavities by all or part of the modulated optical signal $S^{(m)}(t)$;
   - a step of measuring the intensities, amplitudes and/or phases of the optical fields of the cavities;
   - a step of linear transformation on the amounts measured associated with the fields;

- a machine learning step for linear transformation.

28. The method according to claim 27, **characterised in that** the mixing/multiplication step is performed by a module consisting of an optical local oscillator generating the optical carrier wave c(t), and a signal modulator generating a signal $S^{(m)}(t)$ by phase or amplitude modulation of the optical carrier according to the radiofrequency input signal $s^{(m)}(t)$.

29. The method according to claim 27 or 28, **characterised in that** the angular frequency $\omega_p$ of the optical carrier wave $c(t) \sim \exp(-i\omega_p t)$ is chosen such that $\omega_p = \omega - \omega_0$, where $\omega$ denotes the centre of the spectrum of the array of optical cavities, and $\omega_0$ the centre of the radiofrequency spectral range on which the analysis of the input signals is carried out.

30. The method according to claim 29, **characterised in that** the width $\Delta\omega$ of the spectral range of analysis is equal to the spectral width of the array (21) of cavities.

31. The method according to any of claims 27 to 30, **characterised in that** the amplitude of the effective pumping of the individual cavities constituting the array (21) is proportional to the amplitude of the optical signal routed to the cavities of the array.

32. The method according to any of claims 27 to 31, **characterised in that** the step of measuring the physical amounts associated with the fields of the optical cavities provides these amounts in numerical format in the form of a vector of numbers $x^{(m)}$ where m is the index associated with the m-th input signal $s^{(m)}(t)$ to be analysed.

33. The method according to claim 32, **characterised in that** the linear transformation step performs affine transformations of the vector of numbers $x^{(m)}$, returning vectors $(\hat{y}_1^{(m)},...,\hat{y}_K^{(m)})$ of the form $\hat{y}_1^{(m)} = W_i \cdot X^{(m)} + b_i$.

34. The method according to claim 33, **characterised in that** the machine learning step is performed to adjust the parameters $(W_i, b_i)$ of the affine transformations, a set of N train training signals $s^{(m)}(t)$ (m=1,...,$N_{train}$), of which K features of interest describable by a series of vectors $(y_1^{(m)},...,y_K^{(m)})$ are known to generate $N_{train}$ vectors of numbers $(X^{(1)},...,X^{(Ntrain)})$, each vector being transformed in order to obtain a series of predictions $(\hat{y}1^{(m)},...,\hat{y}K^{(m)})$ associated with the target features $(y1^{(m)},...,y_K^{(m)})$.

35. The method according to claim 34, **characterised in that** the parameters $(W_i, b_i)$ are adjusted such that the error $E_{train}$ between the predictions $(\hat{y}_1^{(m)},...,\hat{y}_K^{(m)})$ and the targeted amounts $(y1^{(m)},...,y_K^{(m)})$ is minimised.

36. The method according to claim 35, **characterised in that** once the weights $(W_i, b_i)$ are fixed at their optimum values, the quality of the prediction is evaluated on a series of $N_{test}$ test signals $s^{(m)}(t)$ with targeted features known in advance.

37. A method for extracting features contained in the spectrum of continuous or pulsed, noised, analogue radiofrequency signals forming an analogue input signal, the method using the device according to one of claims 21 to 26, and comprising:

- a step of mixing/multiplying the radiofrequency input signal by modulation of an optical carrier wave, to form a modulated optical signal;
- a step of optically coupling and pumping an array of linear optical cavities by all or part of the modulated optical signal;
- a step of linearly superposing the optical fields radiated by the cavities of the array;
- a step of optically measuring the intensities, amplitudes and/or phases of the linear superpositions of the optical fields radiated by the coupled linear cavities, each linear superposition of the optical fields radiated by the cavities of the array being expressed as a weighted sum of these fields, the weight matrix W and bias vector of which are derived from machine learning on training noised analogue radiofrequency signals.

38. The method according to claim 37, **characterised in that** the weight matrix W is a complex number matrix.

39. The method according to claim 37 or 38, **characterised in that** the generation of the linear superpositions is performed after extracting N components of distinct wavelengths from the collected optical field.

40. A use of a device according to any of claims 1 to 26, in determining the spectral density of a radiofrequency signal.

41. The use of a device according to any of claims 1 to 26, in determining the angular frequency of a targeted maximum in the spectrum of a radiofrequency signal.

42. The use of a device according to any of claims 1 to 26, in determining the frequency of a harmonic signal.

43. The use of a device according to any of claims 1 to 26, in telecommunications, for example, to decode signals from the FSK protocol.

44. The use of a device according to any of claims 1 to 26, for pulsed Doppler radar analysis.

45. An application of the method according to any of claims 27 to 36, or 37 to 39, in determining the spectral energy density and/or the dominant frequency of a radiofrequency pulse.

Fig. 1

Fig. 2

Fig. 3

Fig. 4

Fig. 5

Fig. 6

Fig. 7

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2014116128 A

- US 5481183 A